# EUROPÄISCHE PATENTSCHRIFT

(11) **EP 1 222 662 B1**
(45) Veröffentlichungstag und Bekanntmachung des Hinweises auf die Patenterteilung: **28.05.2003**
(21) Anmeldenummer: 00974329.5
(22) Anmeldetag: 21.09.2000
(51) Int. Cl.: G11C 11/56, G11C 11/15

(54) **MEHRWERTIGER MAGNETORESISTIVER SCHREIB/LESE-SPEICHER SOWIE VERFAHREN ZUM BESCHREIBEN UND AUSLESEN EINES SOLCHEN SPEICHERS**
POLYVALENT, MAGNETORESISTIVE WRITE/READ MEMORY AND METHOD FOR WRITING AND READING A MEMORY OF THIS TYPE
MEMOIRE DE LECTURE/ECRITURE MAGNETORESISTIVE POLYVALENTE AINSI QUE PROCEDE D'ECRITURE ET DE LECTURE D'UNE TELLE MEMOIRE

(30) Priorität: 28.09.1999 DE 19946490
(43) Veröffentlichungstag der Anmeldung: 17.07.2002
(73) Patentinhaber: Infineon Technologies AG, 81669 München (DE)
(72) Erfinder: THEWES, Roland, 82194 Gröbenzell (DE); WEBER, Werner, 80637 München (DE); SCHWARZL, Siegfried, 85579 Neubiberg (DE)
(74) Vertreter: Viering, Hans-Martin, Dipl.-Ing.
(86) Internationale Anmeldenummer: DE0003293
(87) Internationale Veröffentlichungsnummer: WO01024190

(56) Entgegenhaltungen:
- US-A- 5 734 605
- US-A- 5 864 498
- US-A- 5 930 164
- JEONG W -C ET AL: "A NEW MULTILAYERED STRUCTURE FOR MULTILEVEL MAGNETORESISTIVE RANDOM ACCESS MEMORY (MRAM) CELL" IEEE TRANSACTIONS ON MAGNETICS,US,IEEE INC. NEW YORK, Bd. 34, Nr. 4, PART 01, Juli 1998 (1998-07), Seiten 1069-1071, XP000833048 ISSN: 0018-9464
- RUILI ZHANG ET AL: "Demonstration of a four state sensing scheme for a single Pseudo-Spin Valve GMR bit" DIGESTS OF INTERMAG 99. 1999 IEEE INTERNATIONAL MAGNETICS CONFERENCE, KYONGJU, SOUTH KOREA, 18-21 MAY 1999, Bd. 35, Nr. 5, pt.1, Seiten 2829-2831, XP002154833 IEEE Transactions on Magnetics, Sept. 1999, IEEE, USA ISSN: 0018-9464

## Beschreibung

Die vorliegende Erfindung betrifft zunächst einen magnetoresistiven Schreib/Lese-Speicher gemäß dem Oberbegriff von Patentanspruch 1. Weiterhin betrifft die Erfindung ein Verfahren zum Beschreiben eines solchen Speichers gemäß dem Oberbegriff von Patentanspruch 7 sowie ein Verfahren zum Auslesen eines solchen Speichers gemäß dem Oberbegriff von Patentanspruch 11.

Bei magnetoresistiven Schreib/Lese-Speichern, die als MRAM-Speicher (magnetoresistive random access memory) bezeichnet werden, handelt es sich um Speicher, bei denen man unter einer Adresse Daten abspeichern und auch wieder auslesen kann. Die Speicher weisen in der Regel eine oder mehrere Speicherzellen auf, wobei der Speichereffekt im magnetisch veränderbaren elektrischen Widerstand der Speicherzelle beziehungsweise der Speicherzellen liegt.

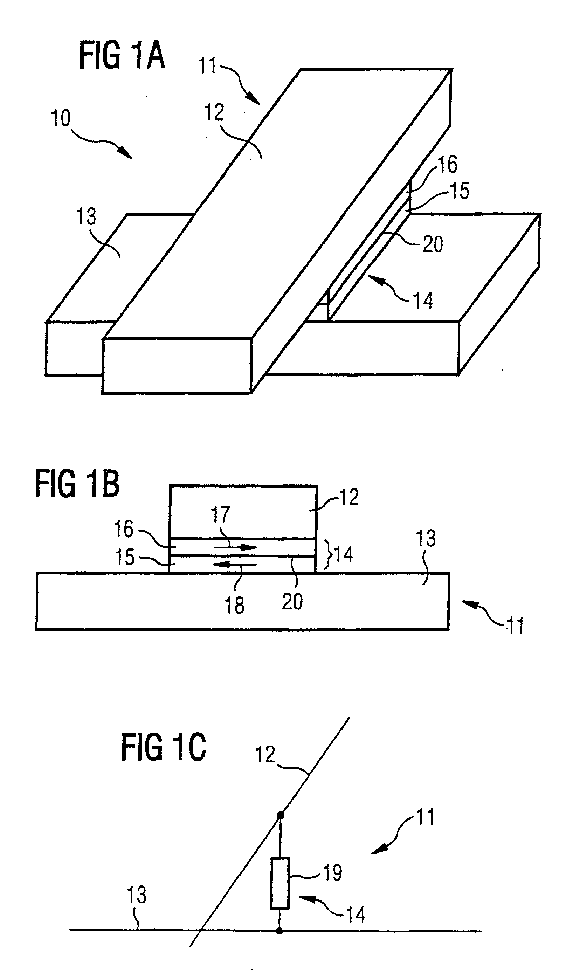

Bisher geht die Entwicklung dahin, für die magnetoresistiven Speicher sogenannte einwertige Speicherzellen mit binärem Speicherinhalt zu verwenden. Diese Speicherzellen bestehen aus zwei gekreuzten elektrischen Leitern, die vorzugsweise senkrecht zueinander ausgerichtet sind. An der Kreuzungsstelle zwischen diesen Leitern befindet sich ein Schichtsystem aus zwei magnetischen Schichten, wobei eine der Schichten aus weichmagnetischem Material und die andere Schicht aus hartmagnetischem Material gebildet ist. Zwischen den magnetischen Schichten befindet sich ein Tunneloxid. Eine solche Speicherzelle ist in der Figurenbeschreibung in Zusammenhang mit Fig.1 beschrieben. In Abhängigkeit vom Magnetisierungszustand können die Magnetisierungsrichtungen in den magnetischen Schichten parallel oder antiparallel ausgerichtet sein. Je nach Magnetisierungsrichtung in den magnetischen Schichten weist die Speicherzelle einen unterschiedlichen elektrischen Widerstand auf. Dabei führt eine parallele Magnetisierungsrichtung zu einem niedrigeren elektrischen Widerstand der Speicherzelle, während eine antiparallele Magnetisierungsrichtung zu einem höheren Widerstand führt.

Im Hinblick auf das Beschreiben solcher Speicherzellen, beziehungsweise das Abspeichern von Informationen in solchen Speicherzellen, wird bisher davon ausgegangen, daß nur das weichmagnetische Material der Speicherzelle ummagnetisiert wird, während das hartmagnetische Material nicht ummagnetisiert wird. Die Ummagnetisierung erfolgt dadurch, daß in die beiden elektrischen Leiter gleichzeitig hohe Ströme eingeprägt werden. Das durch diese Ströme an der Kreuzungsstelle der beiden elektrischen Leiter generierte Magnetfeld besitzt dort eine hinreichend hohe Feldstärke für die Ummagnetisierung der weichmagnetischen Schicht.

Derartige einwertige Speicherzellen weisen jedoch eine Reihe von Nachteilen auf. So ist deren Speicherkapazität aufgrund des binären Speicherinhalts zunächst beschränkt. Zum Speichern großer Informationsmengen ist daher eine große Anzahl von Speicherzellen erforderlich, was einen erhöhten Flächenbedarf für den gesamten Speicher nach sich zieht.

Das Auslesen der Speicherzellen kann beispielsweise über eine entsprechende Widerstandsmessung erfolgen. Wenn sich der Informationsgehalt der Speicherzelle ändert, ändert sich auch deren elektrischer Widerstand. Dieser geänderte Widerstand, beziehungsweise diese Widerstandsänderung, kann dann gemessen werden.

Bei einem weiteren, bekannten Verfahren zum Auslesen von Informationen aus einem magnetoresistiven Speicher handelt es sich um das sogenannte "zerstörende Lesen" mittels Detektion von Spannungs- oder Strompulsen. Dieses Verfahren stellt im Prinzip einen Schreibvorgang dar, bei dem in die Speicherzelle eine definierte Information eingeschrieben wird. Je nachdem, ob die Speicherzelle dabei eine Änderung ihres Informationsgehaltes erfährt oder nicht, kann an der entsprechenden Leseleitung ein Strom- oder Spannungspuls, oder aber das Ausbleiben eines solchen Impulses detektiert werden. Dabei hat jeder Lesevorgang einen Informationsverlust der Zelle zur Folge. Zum Ausgleich dieses Verlustes wird die ausgelesene Information nach Beendigung des Lesevorgangs erneut in die Speicherzelle zurückgeschrieben.
Aus US-A-5,734,605 ist eine einwertige MRAM-Speicherzelle bekannt, bei der zwischen zwei elektrischen Leitern zwei oder mehr magnetische Schichten angeordnet sind. Infolge einer ferromagnetischen Kopplung zwischen den magnetischen Schichten sind deren Magnetisierungsrichtungen in Abwesenheit eines magnetischen Feldes zueinander stets parallel orientiert. Die in der Speicherzelle gespeicherte Information ist in der Richtung der gemeinsamen Orientierung der magnetischen Schichten kodiert. Zum Auslesen der Information wird eine auf dem Riesenmagnetowiderstandseffekt beruhende mögliche Veränderung des elektrischen Widerstands der Schichten detektiert, indem ein zum Umklappen der Magnetisierungsrichtung einer ersten magnetischen Schicht ausreichendes Magnetfeld, das zum Umklappen der Magnetisierungsrichtung einer zweiten magnetischen Schicht nicht ausreicht, angelegt wird.

Im Hinblick auf das Problem des erhöhten Flächenbedarfs einwertiger Speicherzellen zur Erzielung leistungsfähiger Speichersysteme sind zwischenzeitlich mehrwertige Speicherkonzepte entwickelt worden, die jedoch bisher nur für andere Typen von Speichern als den MRAMs vorgeschlagen werden. Bei einem solchen Speichertyp handelt es sich beispielsweise um einen EEPROM (electrically erasable PROM), der sich elektrisch schreiben und löschen läßt. Hierbei werden bestimmte Teilbereiche eines prinzipiell kontinuierlichen Wertebereichs mit diskreten Zuständen gleichgesetzt. Derartige Zuordnungen können in MRAM-Speicherzellen nicht vorgenommen werden, da keine Speicherung kontinuierlich veränderbarer Informationen möglich ist. MRAM-Speicherzellen stellen nämlich vom Prinzip her schon grundsätzlich ein System mit einer endlichen Anzahl diskreter Zustände dar. Die Ansätze zur Mehrwertigkeit im Hinblick auf die genannten EEPROMs lassen sich somit nicht auf die magnetoresistiven Speicher übertragen.

Jeong et al. (Jeong, WC, Lee, BI, Joo, SK (1998) "A New Multilayered Structure for Multilevel Magnetoresistive Random Access Memory (MRAM) cell", IEEE Transactions on Magnetics, US, IEEE Inc., New York, Bd. 34, Nr. 4, Part 01, S.1069-1071) haben anhand einer Schichtenfolge aus magnetischen Nickel-Eisen-, Nickel-Eisen/Kobalt- und Kobalt-Schichten, jeweils voneinander getrennt durch eine Kupfer-Zwischenschicht und ausgebildet auf einer Silizium-Kupfer-Doppelschicht, gezeigt, dass aufgrund unterschiedlicher Koerzitivfeldstärken der drei magnetischen Schichten mittels Anlegens eines durchstimmbaren magnetischen Feldes die Magnetisierungsrichtungen der magnetischen Schichten einzeln umklappbar sind. Dieses Phänomen wurde anhand einer jeweils sprunghaften Änderung des mittels einer Vierpunktmessung erfassten Widerstands der Schichtenfolge infolge des Riesenmagnetowiderstandeffekts gemessen. Ferner wurde von Jeong et al. vorgeschlagen, die einzelnen Magnetisierungsrichtungen der magnetischen Schichten in einer Reihenfolge beginnend mit der magnetischen Schicht mit der größten magnetischen Härte bis hin zu derjenigen magnetischen Schicht mit der geringsten elektrischen Härte einzustellen.

Im Hinblick auf mehrwertige Strukturen ist weiterhin die US-A-5,585,986 bekannt, die einen digitalen magnetoresistiven Sensor zum Auslesen eines Magnetdatenspeichersystems offenbart. Dieser Sensor weist eine Mehrschichtstruktur auf, deren elektrischer Widerstand gemessen wird. Die Mehrschichtstruktur besteht aus einer Anzahl ferromagnetischer Schichten, wobei die magnetischen Momente und damit die Magnetisierungsrichtungen der einzelnen Schichten durch ein externes Magnetfeld, das von dem entsprechenden Datenträger erzeugt wird,
beeinflußt werden. Die Magnetisierungsrichtungen der ferromagnetischen Schichten der Mehrschichtstruktur sollen auf Basis unterschiedlicher Magnetfeldstärken unabhängig voneinander einstellbar sein. Auf diese Weise ändert sich der Widerstand des Sensors in gestuften Schritten, wenn das externe Magnetfeld variiert wird, wodurch ein digitales Ausgangssignal geschaffen wird.

Ausgehend vom genannten Stand der Technik sollen ein magnetoresistiver Schreib/Lese-Speicher sowie ein Verfahren zum Beschreiben und zum Auslesen eines solchen Speichers bereitgestellt werden, bei dem/denen die zum Stand der Technik beschriebenen Nachteile und Probleme vermieden werden. Insbesondere sollen im Hinblick auf eine mögliche Flächenersparnis ein verbesserter MRAM-Speicher sowie ein geeignetes Verfahren zum Beschreiben und Auslesen eines solchen MRAM-Speichers bereitgestellt werden.

Diese Aufgabe wird gemäß dem ersten Aspekt der Erfindung durch einen magnetoresistiven Schreib/Lese-Speicher gemäß Anspruch 1 gelöst.

Auf diese Weise wird ein mehrwertiger Speicher mit einer oder mehreren mehrwertigen Speicherzellen und damit mit einer entsprechend hohen Speicherkapazität geschaffen. Weiterhin kann dieser Speicher beziehungsweise die wenigstens eine Speicherzelle auf einfache Weise beschrieben und/oder ausgelesen werden.

Ein grundlegendes Merkmal des erfindungsgemäßen Speichers beziehungsweise der den Speicher bildenden Speicherzelle oder Speicherzellen besteht darin, an der Kreuzungsstelle der beiden elektrischen Leiter ein n-lagiges Mehrschichtsystem mit n größer oder gleich zwei magnetischen Schichten zu verwenden, wobei in m Schichten, mit n größer oder gleich m und m größer oder gleich zwei, die Magnetisierungsrichtung unabhängig von der Magnetisierungsrichtung in den anderen Schichten einstellbar ist. Während bei den einwertigen Speichern die Magnetisierungsrichtung in nur einer magnetischen Schicht eingestellt wird, kann dies bei den erfindungsgemäßen mehrwertigen Speichern nunmehr in einer beliebig großen Anzahl von magnetischen Schichten erfolgen. Dabei kann die Anzahl der magnetischen Schichten je nach Bedarf und Anwendungsfall variieren, so daß die Erfindung nicht auf eine bestimmte Anzahl von Schichten beschränkt ist. Ein ähnliches Mehrschichtsystem ist grundsätzlich bereits in der US-A-5,585,986 beschrieben.

Ein weiteres grundlegendes Merkmal für den erfindungsgemäßen Speicher besteht darin, daß die Magnetisierungsrichtung in den einzelnen Schichten aufgrund des durch die elektrischen Leiter fließenden elektrischen Stroms geändert wird oder änderbar ist.

Um die Magnetisierungsrichtungen in den einzelnen magnetischen Schichten unabhängig voneinander einstellen zu können, muß erreicht werden, daß die Einstellung der Magnetisierungsrichtung (Ummagnetisierung) in den einzelnen Schichten bei jeweils unterschiedlichen Feldstärken, beziehungsweise Strömen in den Leitern, hervorgerufen wird.

In der US-A-5,585,986 wird diese Anforderung dadurch gelöst, daß das Mehrschichtsystem einen kristallinen Aufbau hat und daß die einzelnen Schichten unterschiedliche kristalline Symmetrien und damit magnetische Anisotropien aufweisen. Weiterhin weisen die Schichten eine unterschiedliche Dicke und Schichtmorphologie auf. Wenn das Mehrschichtsystem einem Magnetfeld mit jeweils spezifischer Feldstärke ausgesetzt wird, wird die Magnetisierungsrichtung in einzelnen oder mehreren Schichten aufgrund der Feldstärke des anliegenden Magnetfeldes sowie der spezifischen Ausgestaltung der jeweiligen Schicht entweder geändert oder nicht. Ein solches System ist aufgrund des komplexen Herstellvorgangs für das Mehrschichtsystem besonders aufwendig und kostenintensiv.

Mit dem erfindungsgemäßen magnetoresistiven Speicher wird ein anderer Weg beschritten. Dieser Weg läßt die Herstellung von magnetischen Schichten mit im wesentlichen gleichen Strukturen und Morphologien zu. Die jeweilige, individuelle Einstellung der Magnetisierungsrichtungen in den einzelnen Schichten wird über jeweils unterschiedliche Feldstärken durch unterschiedliche Stromstärken hervorgerufen. Dazu fließt durch die beiden, sich kreuzenden Leiter jeweils ein elektrischer Strom, auf Grund dessen sich um die beiden Leiter jeweils ein magnetisches Feld bildet. Das magnetische Feld wirkt auf die einzelnen magnetischen Schichten des Mehrschichtsystems, wodurch diese bei ausreichend hohen Feldstärken ummagnetsisiert werden können. Die Ummagnetisierung einzelner Schichten ist somit abhängig von der Größe der die beiden Leiter durchfließenden Ströme und der räumlichen Anordnung der jeweiligen magnetischen Schicht in Bezug auf die elektrischen Leiter.

Als geeignetes Lese- und/oder Schreibwerkzeug für den Speicher fungieren somit die sich kreuzenden Leiter, in die der das Feld erzeugende Strom eingeprägt wird. Während bei einwertigen Speichern ein fester Strom in die Leiter eingeprägt wird, der die Magnetisierungsrichtung in der ummagnetisierbaren magnetischen Schicht entweder ändert oder nicht, wird im Zusammenhang mit der vorliegenden Erfindung ausgenutzt, daß eine Änderung der magnetischen Feldstärke dazu geeignet ist, die Magnetisierungsrichtung in einer Vielzahl von magnetischen Schichten unabhängig voneinander und individuell einstellen zu können. Die Bereitstellung von unterschiedlichen magnetischen Feldstärken kann auf verschiedene Art und Weise erfolgen, wie im weiteren Verlauf der Beschreibung näher erläutert wird.

Vorteilhafte Ausführungsformen des erfindungsgemäßen Speichers ergeben sich aus den Unteransprüchen.

Vorzugsweise können die unabhängig voneinander einstellbaren Magnetisierungsrichtungen in den einzelnen Schichten über unterschiedliche Stromstärken eingestellt werden oder einstellbar sein. Dies kann je nach Ausgestaltung der Speicherzellen auf unterschiedliche Weise erfolgen. So ist es beispielsweise denkbar, daß zur Einstellung unterschiedlicher Magnetisierungsrichtungen in einzelnen magnetischen Schichten Ströme mit unterschiedlichen Stromstärken in die elektrischen Leiter eingeprägt werden. Durch die unterschiedlichen Stromstärken werden jeweils unterschiedliche Feldstärken erzeugt, die dann zu einer Änderung der Magnetisierungsrichtung in einer oder mehreren Schichten führen oder nicht.

In weiterer Ausgestaltung können die elektrischen Leiter für hohe Stromdichten ausgelegt sein.

Die einzelnen magnetischen Schichten sind vorzugsweise aus einem ferromagnetischen Material gebildet. Jedoch ist die Erfindung nicht auf bestimmte Materialtypen beschränkt, so daß auch andere geeignete Materialien möglich sind.

Vorteilhaft können die sich kreuzenden elektrischen Leiter orthogonal zueinander ausgerichtet sein.

In weiterer Ausgestaltung ist zwischen zwei benachbarten magnetischen Schichten jeweils ein Tunneldielektrikum vorgesehen. Die elektronische Leitfähigkeit durch ein solches Mehrschichtsystem aus magnetischen Schichten und dazwischen liegenden Tunneldielektrikumsschichten wird im wesentlichen durch den Tunneleffekt durch das Tunneldielektrikum bestimmt. Deshalb ist die Auswahl einer geeigneten Dicke für das Tunneldielektrikum von besonderer Bedeutung, da Variationen in der Schichtdicke zu starken Variationen in der Leitfähigkeit führen, weil die Dicke der Schicht näherungsweise exponentiell in den Tunnelstrom eingeht. Vorzugsweise -jedoch nicht ausschließlich- werden deshalb dünne Tunneldielektrikumsschichten mit einer Dicke von 2 bis 3 Nanometern (nm) verwendet.

Gemäß einem zweiten Aspekt der vorliegenden Erfindung wird ein Verfahren zum Beschreiben eines wie vorstehend beschriebenen erfindungsgemäßen magnetoresistiven Schreib/Lese-Speichers bereitgestellt, das erfindungsgemäß durch folgende Schritte gekennzeichnet ist: a) Einprägen eines veränderbaren elektrischen Stroms in die beiden elektrischen Leiter und dadurch Erzeugen eines magnetischen Feldes; und b) Einstellen der Magnetisierungsrichtung in den einzelnen magnetischen Schichten des Mehrschichtsystems über die Feldstärke des erzeugten magnetischen Feldes, wobei die Magnetisierungsrichtungen in den einzelnen Schichten unabhängig voneinander über jeweils unterschiedlich hohe benötigte Feldstärken eingestellt werden, derart, daß die Magnetisierungsrichtungen zuerst in denjenigen Schichten eingestellt werden, die dazu die höchste Feldstärke benötigen und daß anschließend die Magnetisierungsrichtungen in denjenigen Schichten eingestellt werden, die dazu jeweils eine niedrigere Feldstärke benötigen.

Durch das erfindungsgemäße Verfahren wird es auf einfache Weise möglich, einen mehrwertigen magnetoresitiven Speicher, beziehungsweise dessen Speicherzelle oder Speicherzellen zu beschreiben. Erfindungsgemäß muß die Reihenfolge der Speicherung der Informationen in den einzelnen magnetischen Schichten so gewählt werden, daß die Schichten einer Speicherzelle in der Reihenfolge abnehmender Feldstärke für die Ummagnetisierung der Schichten (das bedeutet mit jeweils gemäß den an der entsprechenden Schicht gewünschten Feldstärke angepaßten Programmierstromstärken) beschrieben werden. Dadurch wird gewährleistet, daß bereits in die Speicherzelle eingeschriebene Informationen, die in eine Schicht mit höherer Programmierfeldstärke eingeschrieben wurden, bei Einschreibung von Informationen in weitere Schichten, die dann bei jeweils niedrigeren Programmierfeldstärken eingeschrieben werden, nicht wieder überschrieben werden.

Zu den Vorteilen, Wirkungen, Effekten und der Funktionsweise des erfindungsgemäßen Verfahrens wird weiterhin auch auf die vorstehenden Ausführungen zum erfindungsgemäßen Speicher vollinhaltlich Bezug genommen und hiermit verwiesen. Vorteilhafte Ausgestaltungsformen des erfindungsgemäßen Verfahrens ergeben sich aus den Unteransprüchen.

Vorzugsweise können die auf die Schichten wirkenden unterschiedlichen Feldstärken erzeugt werden, indem unterschiedlich große Ströme in die Leiter eingeprägt werden. Die auf die Schichten wirkenden unterschiedlichen Feldstärken werden ferner durch einen unterschiedlichen räumlichen Abstand der Schichten zu den elektrischen Leitern bestimmt.

Weiterhin ist es auch denkbar, daß für die Einstellung der Magnetisierungsrichtungen in den Schichten aufgrund unterschiedlich hoher Feldstärken durch Eigenschaften des Schichtmaterials und/oder die Schichtdicke und/oder die Schichtmorphologie beeinflußt wird.

Da die genannten Beispiele weiter oben bereits ausführlich beschrieben worden sind, wird an dieser Stelle auf die genannten Ausführungen verwiesen.

Gemäß dem dritten Aspekt der vorliegenden Erfindung wird ein Verfahren zum Auslesen eines wie vorstehend beschriebenen erfindungsgemäßen magnetoresistiven Schreib/Lese-Speichers bereitgestellt, das erfindungsgemäß durch folgende Schritte gekennzeichnet ist: a) Einprägen eines definierten Datums in die einzelnen Schichten des Mehrschichtsystems derart, daß das Datum zunächst in diejenige Schicht eingeprägt wird, die zur Einstellung der Magnetisierungsrichtung die niedrigste Feldstärke benötigt und daß das Datum anschließend in die Schichten mit den jeweils nächst höheren benötigten Feldstärken eingeprägt wird; und b) Erfassen einer möglichen Informationsänderung in der Schicht beziehungsweise den Schichten aufgrund des eingeprägten definierten Datums.

Durch das erfindungsgemäße Verfahren kann ein mehrwertiger magnetoresitiver Speicher auf einfache Weise ausgelesen werden. Zu den Vorteilen, Wirkungen, Effekten und der Funktionsweise des erfindungsgemäßen Verfahrens wird zusätzlich zu der nachfolgenden Beschreibung auch auf die vorstehenden Ausführungen zum erfindungsgemäßen Speicher sowie zum erfindungsgemäßen Verfahren zum Beschreiben eines Speichers vollinhaltlich Bezug genommen und hiermit verwiesen.

Der Grundgedanke des erfindungsgemäßen Verfahrens zum Auslesen eines Speichers besteht darin, daß in die einzelnen magnetischen Schichten der Speicherzelle oder der Speicherzellen nacheinander jeweils ein bestimmtes Datum, das heißt eine bestimmte Information, eingeschrieben wird. Wenn sich der Informationsgehalt der Schicht nach dem Einprägen des bestimmten Datums ändert bedeutet dies, daß die Schicht zuvor mit einer anderen Information beschrieben war. Wenn sich der Informationsgehalt der Schicht nach dem Einprägen des bestimmten Datums nicht ändert, bedeutet dies, daß die Schicht zuvor auch mit der gleichen Information beschrieben war. Dabei ist von besonderer Bedeutung, daß das Zieldatum bekannt ist. Als Zieldatum ist dasjenige Datum zu verstehen, das, wie vorstehend beschrieben, gezielt in die Speicherzelle eingeschrieben wird.

Die mögliche Informationsänderung beziehungsweise das Ausbleiben einer Informationsänderung kann auf geeignete Weise erfaßt und anschließend ausgewertet werden. Exemplarische Beispiele hierfür werden im weiteren Verlauf der Beschreibung näher erläutert.

Um das Auslesen der Speicherzelle beziehungsweise Speicherzellen des Speichers optimal ausführen zu können, werden zunächst solche Schichten ausgelesen, das heißt mit dem bestimmten Datum gezielt umgeschrieben, die zur Einstellung der Magnetisierungsrichtung die geringste Programmierfeldstärke benötigen. Das bestimmte Datum wird somit in der Reihenfolge zunehmender Programmierfeldstärke in die Speicherzelle, beziehungsweise die einzelnen Schichten des Mehrschichtsystems der Speicherzelle, geschrieben.

Vorteilhafte Ausführungsformen des erfindungsgemäßen Verfahrens ergeben sich aus den Unteransprüchen.

Vorzugsweise kann die mögliche Informationsänderung in der Schicht beziehungsweise den Schichten über eine Messung des elektrischen Widerstands erfolgen. Da der elektrische Widerstand der Speicherzelle von den Magnetisierungsrichtungen (parallel oder antiparallel) der einzelnen Schichten abhängt und sich die Magnetisierungsrichtungen aufgrund möglicher Informationsänderungen ändern können, bedeutet eine Änderung des elektrischen Widerstands, daß sich der Informationsgehalt der Speicherzelle beziehungsweise einzelner Schichten der Speicherzelle geändert hat.

Auch kann die mögliche Informationsänderung in der Schicht beziehungsweise den Schichten über eine Detektion von Stromund/oder Spannungspulsen erfolgen. Wenn das Einschreiben des bestimmten Datums in die Schichten des Speicherzeile zu einer Informationsänderung führt, tritt dabei auch ein Stromund/oder Spannungspuls auf, der detektiert werden kann. Für den Fall, daß kein Strom- und/oder Spannungspuls detektiert wird, bedeutet dies, das auch keine Informationsänderung in der Schicht beziehungsweise den Schichten stattgefunden hat.

Vorzugsweise kann die Erfassung einer möglichen Informationsänderung in der Schicht beziehungsweise den Schichten vor und nach dem Einprägen und/oder während des Einprägens des bestimmten Datums in die Schicht beziehungsweise die Schichten erfolgen.

In vorteilhafter Ausgestaltung kann in alle Schichten nacheinander ein bestimmtes Datum mit jeweils gleichem Wert eingeprägt werden. Wenn in den Speicherzellen Informationen in binärer Form, das heißt mit logischen Werten "1" und "0" gespeichert sind, kann das bestimmte Datum, das nacheinander in alle Schichten der Speicherzelle eingeschrieben wird, entweder den logischen Wert "1" oder "0" aufweisen.

In anderer Ausgestaltung ist es auch denkbar, daß in die Schichten nacheinander ein Datum eingeprägt wird, daß einem alternierenden Algorithmus gehorcht.

Vorteilhaft können die Ergebnisse bei der Erfassung einer möglichen Informationsänderung für jede Schicht zumindest temporär in einer geeigneten Speichereinrichtung zwischengespeichert werden.

Die Erfindung wird nun anhand von Ausführungsbeispielen unter Bezugnahme auf die beiliegende Zeichnung näher erläutert. Es zeigen:
- Fig.1a: in schematischer, perspektivischer Ansicht eine magnetoresistive Speicherzelle gemäß dem Stand der Technik;
- Fig.1b: eine schematische Querschnittsansicht der Speicherzelle gemäß Fig.1a;
- Fig.1c: ein Ersatzschaltbild für eine Speicherzelle gemäß Fig.1a;
- Fig.2: eine schematische Querschnittsansicht einer ersten Ausführungsform einer erfindungsgemäßen mehrwertigen, hier zweiwertigen, Speicherzelle, wobei in den Teilansichten a) bis d) unterschiedliche Magnetisierungszustände dargestellt sind; und
- Fig.3: eine Querschnittsansicht einer anderen Ausführungsform der erfindungsgemäßen mehrwertigen Speicherzelle.

In den Fig.1a bis 1c ist eine Speicherzelle 11 eines magnetoresistiven Speichers 10 gemäß dem Stand der Technik dargestellt. Die Speicherzelle 11 ist als einwertige Speicherzelle ausgebildet und weist einen oberen 12 und einen unteren 13 elektrischen Leiter auf, die orthogonal zueinander ausgerichtet und an einer Kreuzungsstelle der Speicherzelle 11 gekreuzt sind. An der Kreuzungsstelle befindet sich ein Schichtsystem 14 mit zwei magnetischen Schichten, einer hartmagnetischen Schicht 15 und einer weichmagnetischen Schicht 16. Zwischen den Schichten 15, 16 befindet sich ein Tunneldielektrikum 20. Für die Speicherzelle 11 kann ein Ersatzschaltbild gemäß Fig.1c angegeben werden, wobei der Wert des darin enthaltenen Widerstands 19 zwischen den Leitern 12, 13 davon abhängt, ob die Magnetisierungsrichtungen 17, 18 in den magnetischen Schichten 15, 16 parallel oder antiparallel liegen. Das Beispiel gemäß Fig.1b zeigt eine antiparallele Ausrichtung der Magnetisierungsrichtungen. Eine parallele Magnetisierungsrichtung führt zu einem niedrigeren Widerstandswert, während eine antiparallele Magnetisierungsrichtung zu einem höheren Widerstandswert führt.

Zum Beschreiben der Speicherzelle 11 werden in die Leiter 12, 13 gleichzeitig hohe elektrische Ströme eingeprägt. Das durch diese Ströme an der Kreuzungsstelle der Leiter 12, 13 generierte Magnetfeld besitzt dort eine hinreichend hohe Feldstärke für die Ummagnetisierung der weichmagnetischen Schicht 16.

Die Speicherzelle 11 sowie der aus einer oder mehreren solcher Speicherzellen 11 gebildete Speicher 10 benötigen einen relativ großen Flächenbedarf.

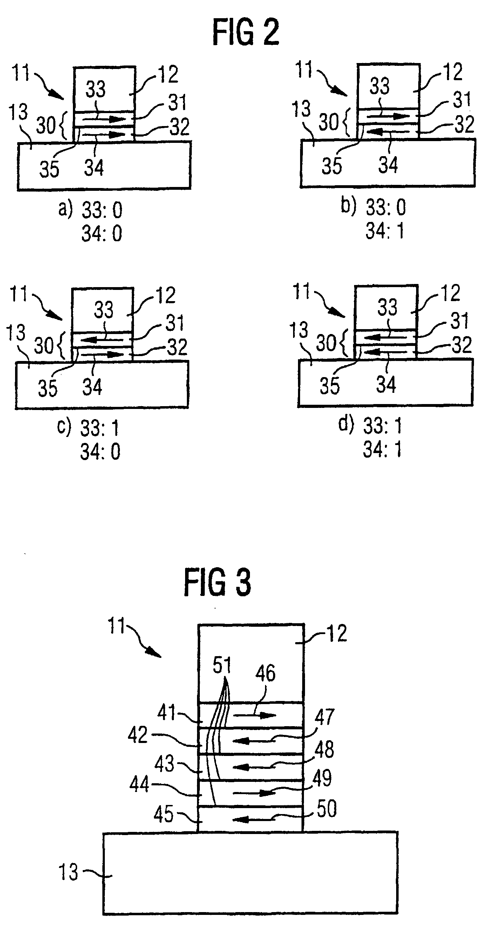

Zur Umgehung dieses Nachteils wird ein mehrwertiger Speicher mit mehrwertigen Speicherzellen vorgeschlagenn. Zwei Ausführungsbeispiele für derartige erfindungsgemäße Speicherzellen sind in den Fig.2 und 3 beschrieben.

In Fig.2 ist schematisch eine sogenannte Zwei-Schichten-2-Bit-Speicherzelle 11 dargestellt. Zwischen den beiden elektrischen Leitern 12, 13 befindet sich an deren Kreuzungsstelle ein Mehrschichtsystem 30 mit mehreren magnetischen Schichten 31, 32 und jeweils dazwischen angeordneten Tunneldielektrika 35.

Grundsätzlich weist das Mehrschichtsystem n magnetische Schichten auf, wobei die Bedingung n ≥ 2 gilt. Von diesen n Schichten kann in m Schichten die Magnetisierungsrichtung unabhängig von den anderen benachbarten Schichten eingestellt werden, wobei gilt: n ≥ m ≥ 2.

Bei dem Ausführungsbeispiel gemäß Fig.2 sind zwei magnetische Schichten 31, 32 dargestellt, deren Magnetisierungsrichtungen 33, 34 jeweils unabhängig voneinander einstellbar sind. Die Teilansichten 2a bis 2d von Fig.2 zeigen dabei die unterschiedlichen möglichen Magnetisierungszustände beziehungsweise Magnetisierungsrichtungen 33, 34 in den magnetischen Schichten 31, 32.

Für die folgende Erläuterung des Informationsgehaltes der Speicherzelle 11 wird als Nomenklatur die Benennung der Magnetisierungsrichtungen mit entsprechenden Bezugsziffern, sowie logisch "0" und logisch "1" eingeführt, wobei die Magnetisierungsrichtungen mit zunehmender Größe der Bezugsziffern für die von oben nach unten gezählten magnetischen Schichten beschrieben sind. Logisch "0" steht für die in den Fig.2 und 3 eingezeichnete Magnetisierungsrichtung "von links nach rechts", logisch "1" steht für die in den Fig.2 und 3 eingezeichnete Magnetisierungsrichtung "von rechts nach links".

Gemäß Fig.2 und den darin gezeigten Teilansichten können in den magnetischen Schichten 31, 32 insgesamt vier unterschiedliche Magnetisierungszustände eingestellt werden. Gemäß Fig2a gilt nach der oben eingeführten Nomenklatur für die eingestellte Magnetisierungsrichtung 33 ein logisch "0", während für die Magnetisierungsrichtung 34 ebenfalls logisch "0" gilt. Gemäß Fig.2b ergibt sich 33 = "0" und 34 = "1". Fig.2c zeigt den Magnetisierungszustand 33 = "1" und 34 = "0", während Fig.2d den Magnetisierungszustand 33 = "1" und 34 = "1" zeigt.

In Fig.3 ist ein weiteres Ausführungsbeispiel für eine Speicherzelle 11 dargestellt. Die Speicherzelle 11 weist wiederum zwei sich kreuzende elektrische Leiter 12, 13 und ein sich an der Kreuzungsstelle der Leiter 12, 13 befindliches Mehrschichtsystem 40 auf, das im vorliegenden Fall aus fünf magnetischen Schichten 40-45 gebildet ist, in denen die jeweiligen Magnetisierungsrichtungen 46-50 jeweils unabhängig von benachbarten Schichten einstellbar sind. Zwischen den magnetischen Schichten befindet sich jeweils ein Tunneldielektrikum 51.

Gemäß der oben eingeführten Nomenklatur weist die Speicherzelle 11 gemäß Fig.3 den folgenden Magnetisierungszustand auf: Schicht 41 hat eine Magnetisierungsrichtung 46 mit logisch "0", Schicht 42 eine Magnetisierungsrichtung 47 mit logisch "1", Schicht 43 eine Magnetisierungsrichtung 48 mit logisch "1", Schicht 44 eine Magnetisierungsrichtung 49 mit logisch "0" und Schicht 45 eine Magnetisierungsrichtung 50 mit logisch "1".

Um die vorstehend erläuterten Speicherzellen 11 gezielt beschreiben zu können, müssen die verschiedenen magnetischen Schichten 31, 32 beziehungsweise 41-45 der Anforderung genügen, daß für ihre Ummagnetisierung unterschiedliche Stromstärken in den felderzeugenden Leitern 12, 13 benötigt werden. Dies kann dadurch erreicht werden, daß in den einzelnen Schichten jeweils unterschiedliche magnetische Feldstärken erforderlich sind. In diesem Fall können in die Leiter 12, 13 unterschiedlich große Ströme eingeprägt werden, die dann die unterschiedlichen Feldstärken für die Ummagnetisierung der einzelnen Schichten erzeugen. Dabei wird zur Bereitstellung unterschiedlich großer Feldstärken zur Einstellung der Magnetisierungsrichtungen in den einzelnen Schichten ferner der unterschiedliche räumliche Abstand der jeweils umzugagnetisierenden Schicht und der Leiter 12, 13 ausgenutzt.

Die Reihenfolge der Speicherung der Informationen in den einzelnen Schichten 31, 32 beziehungsweise 41-45 der Speicherzelle 11 muß so gewählt werden, daß die Schichten der Speicherzelle in der Reihenfolge abnehmender Programmierfeldstärke beschrieben werden. Das bedeutet, daß zunächst diejenigen Schichten beschrieben werden, die zur Einstellung der Magnetisierungsrichtung die höchste Feldstärke benötigen, während anschließend diejenigen Schichten beschrieben werden, die dazu jeweils eine niedrigere Feldstärke benötigen. Dadurch wird gewährleistet, daß bereits in die Speicherzelle 11 eingeschriebene Informationen, die zunächst in eine Schicht mit höherer Programmierfeldstärke eingeschrieben wurden, bei Einschreibung von Informationen in weitere Schichten nicht wieder überschrieben werden können.

Für den Vorgang des Auslesens ist erfindungsgemäß ein Verfahren angegeben, das beispielsweise auf der direkten Messung des Widerstands oder auf der Detektion von Strom- und/oder Spannungspulsen bei Einprägung einer definierten Information in des entsprechende Bit der zu lesenden Speicherzelle 11 basiert. Der Informationsgehalt der Speicherzellen 11 wird während des kompletten Lesevorgangs grundsätzlich geändert. Allerdings wird keine zusätzliche Referenz-Speicherzelle benötigt.

Das Ausleseverfahren wird nun beispielhaft anhand einer m-Bit-Zelle beschrieben, die als 2-Bit-Zelle ausgebildet ist. Diese Zelle weist genau m (mit m = 2) ummagnetisierbare Schichten auf, die jeweils eine Magnetisierungsrichtung MRk aufweisen, wobei MRk die Magnetisierungsrichtung der von oben nach unten gezählten k-ten magnetischen Schicht beschreibt, mit 1 ≤ k ≤ m. Die Speicherzelle enthält die in binärer Form vorliegenden Daten Dk, mit 1 ≤ k ≤ m. Um diese Zelle zu lesen, wird nun in der Reihenfolge zunehmender Programmierfeldstärke (zunächst also in solchen Schichten, die zur Einstellung der Magnetisierungsrichtung eine niedrige Feldstärke benötigen) ein definiertes Datum Ek = Efix, mit 1 ≤ k ≤ m, in diese Zelle geschrieben. Beispielsweise kann dieses Datum für alle k den logischen Wert "0" oder "1" haben.

Vor Beginn dieses Lesevorgangs gilt also MRk = Dk, nach Abschluß MRk = Efix, für alle Schichten k mit 1 ≤ k ≤ m.

Fur den Fall, daß während des k-ten Schreibvorgangs ein Strom- und/oder Spannungspuls detektiert wird, ist dies ein zwingendes Indiz für eine erfolgte Änderung des entsprechenden k-ten Datums, das heißt es gilt Dk = das Komplementätdatum von Efix. Vor dem Einlesen des definierten Datums Efix in die Schicht hatte diese also das Komplementärdatum von Efix gespeichert. Für den Fall, daß kein Strom- und/oder Spannungspuls detektiert wird, gilt Dk = Efix. Somit sind nach Abschluß des Lesevorgangs die kompletten binär vorliegenden Daten der Speicherzelle verfügbar.

Alternativ zur Detektion eines Strom- und/oder Spannungspulses kann auch für jeden Schreibvorgang eine Messung des elektrischen Widerstands jeweils vor und nach der Einprägung des definierten Datums Efix in das entsprechende Bit vorgenommen werden. Im Falle einer m-Bit-Zelle, im vorliegenden Fall einer 2-Bit-Zelle, bedeutet dies, daß insgesamt m+1 Messungen, im vorliegenden Fall 3 Messungen, vorgenommen werden müssen. Die gemessenen Einzelwerte für jede Schicht werden zumindest temporär in einer geeigneten Speichereinrichtung zwischengespeichert. Für den Fall, daß bei den Messungen zum k-ten Bit die Widerstandswerte vor und nach der Einprägung des Datums Efix unterschiedlich sind, gilt, daß Dk vor der Einprägung des Datiums Efix ursprünglich das Komplementätdatum zu Efix war. Im Falle gleicher Widerstandwerte vor und nach der Einprägung des Datums Efix ergibt sich Dk = Efix.

Das vorstehend genannte Ausleseverfahren wurde zum Auslesen von 2-Bit-Zellen verwendet. Ähnliche Verfahren sind jedoch auch für m-Bit-Zellen mit m>2 möglich.

## Patentansprüche

1. Magnetoresistiver Schreib/Lese-Speicher, mit mehreren mehrwertigen Speicherzellen (11), wobei jede Speicherzelle (11) zwei sich kreuzende elektrische Leiter (12, 13) sowie ein sich an der Kreuzungsstelle der elektrischen Leiter (12, 13) befindliches Schichtsystem aus magnetischen Schichten aufweist, wobei
das Schichtsystem als Mehrschichtsystem (30; 40) mit zwei oder mehr magnetischen Schichten (31, 32; 41-45) ausgebildet ist, mindestens zwei, maximal jedoch alle magnetischen Schichten (31, 32; 41-45) eine unabhängig voneinander einstellbare Magnetisierungsrichtung (33, 34; 46-50) aufweisen,
die Magnetisierungsrichtung (33, 34; 46-50) in den einzelnen Schichten (31, 32; 41-45) aufgrund des durch die elektrischen Leiter (12, 13) fließenden elektrischen Stroms geändert wird oder änderbar ist,
zwischen zwei benachbarten magnetischen Schichten (31, 32; 41-46) jeweils ein Tunneldielektrikum (35; 51) vorgesehen ist.

2. Magnetoresistiver Scbreib/Lese-Speicher nach Anspruch 1,
bei dem die unabhängig voneinander einstellbaren Magnetisierungsrichtungen (33, 34; 46-50) in den einzelnen Schichten (31, 32; 41-45) über unterschiedliche Stromstärken eingestellt werden oder einstellbar sind.

3. Magnetoresistiver Schreib/Lese-Speicher nach Anspruch 1 oder 2,
bei dem die elektrischen Leiter (12, 13) für hohe Stromdichten ausgelegt sind.

4. Magnetoresistiver Schreib/Lese-Speicher nach einem der Ansprüche 1 bis 3,
bei dem die magnetischen Schichten (31, 32; 41-45) aus einem ferromagnetischen Material gebildet sind.

5. Magnetoresistiver Schreib/Lese-Speicher nach einem der Ansprüche 1 bis 4,
bei dem die sich kreuzenden Leiter (12, 13) orthogonal zueinander ausgerichtet sind.

6. Magnetoresistiver Schreib/Lese-Speicher nach einem der Ansprüche 1 bis 5,
bei dem das Tunneldielektrikum eine Dicke von 2 bis 3 nm aufweist.

7. Verfahren zum Beschreiben eines magnetoresistiven Schreib/Lese-Speichers nach einem der Ansprüche 1 bis 6, mit den folgenden Schritten:
a) Einprägen eines veränderbaren elektrischen Stroms in die beiden elektrischen Leiter und dadurch Erzeugen eines magnetischen Feldes;
b) Einstellen der Magnetisierungsrichtung in den einzelnen magnetischen Schichten des Mehrschichtsystems über die Feldstärke des erzeugten magnetischen Feldes, wobei die Magnetisierungsrichtungen in den einzelnen Schichten unabhängig voneinander über jeweils unterschiedlich hohe benötigte Feldstärken eingestellt werden, derart, daß die Magnetisierungsrichtungen zuerst in denjenigen Schichten eingestellt werden, die dazu die höchste Feldstärke benötigen und daß anschließend die Magnetisierungsrichtungen in denjenigen Schichten eingestellt werden, die dazu jeweils eine niedrigere Feldstärke benötigen.

8. Verfahren nach Anspruch 7,
bei dem die auf die Schichten wirkenden unterschiedlichen Feldstärken erzeugt werden, indem unterschiedliche große Ströme in die Leiter eingeprägt werden.

9. Verfahren nach Anspruch 7 oder 8,
bei dem die auf die Schichten wirkenden unterschiedlichen Feldstärken durch einen unterschiedlichen räumlichen Abstand der Schichten zu den Leitern erzeugt werden.

10. Verfahren nach einem der Ansprüche 7 bis 9,
bei dem die Einstellung der Magnetisierungsrichtungen in den Schichten aufgrund unterschiedlich hoher Feldstärken durch das Schichtmaterial und/oder die Schichtdicke und/oder die Schichtmorphologie beeinflußt werden.

11. Verfahren zum Auslesen eines magnetoresistiven Schreib/Lese-Speichers nach einem der Ansprüche 1 bis 6, mit den folgenden Schritten:
a) Einprägen eines definierten Datums in die einzelnen Schichten des Mehrschichtsystems derart, daß das Datum zunächst in diejenige Schicht eingeprägt wird, die zur Einstellung der Magnetisierungsrichtung die niedrigste Feldstärke benötigt und daß das Datum anschließend in die Schichten mit den jeweils nächst höheren benötigten Feldstärken eingeprägt wird; und
b) Erfassen einer möglichen Informationsänderung in der Schicht beziehungsweise den Schichten aufgrund des eingeprägten definierten Datums.

12. Verfahren nach Anspruch 11,
bei dem die Erfassung einer möglichen Informationsänderung in der Schicht beziehungsweise den Schichten über eine Messung des elektrischen Widerstands erfolgt.

13. Verfahren nach Anspruch 11 oder 12,
bei dem die Erfassung einer möglichen Informationsänderung in der Schicht beziehungsweise den Schichten über eine Detektion von Strom- und/oder Spannungspulsen erfolgt.

14. Verfahren nach einem der Ansprüche 11 bis 13,
bei dem die Erfassung einer möglichen Informationsänderung in der Schicht beziehungsweise den Schichten vor und nach dem Einprägen und/oder während des Einprägens des bestimmten Datums in die Schicht beziehungsweise die Schichten erfolgt.

15. Verfahren nach einem der Ansprüche 11 bis 14,
bei dem in allen Schichten nacheinander ein Datum mit jeweils dem gleichen Wert eingeprägt wird.

16. Verfahren nach einem der Ansprüche 11 bis 14,
bei dem in die Schichten nacheinander ein Datum eingeprägt wird, das einem alternierenden Algorithmus gehorcht.

17. Verfahren nach einem der Ansprüche 11 bis 16,
bei dem die Ergebnisse bei der Erfassung einer möglichen Informationsänderung für jede Schicht zumindest temporär in einer Speichereinrichtung zwischengespeichert werden.

## Claims

1. A magnetoresistive read/write memory, with a plurality of multivalue storage cells (11), each storage cell (11) having two intersecting electric conductors (12, 13) and a layer system comprising magnetic layers located at the intersection of the electric conductors (12, 13),
• wherein the layer system is designed as a multilayer system (30; 40) with two or more magnetic layers (31, 32; 41-45),
• wherein at least two, but a maximum of all the magnetic layers (31, 32; 41-45) comprise a magnetization direction (33, 34; 46-50) that can be set independently of one another,
• wherein the magnetization direction (33, 34; 46-50) in the individual layers (31, 32; 41-45) is changed or can be changed because of the electric current flowing through the electric conductors (12, 13),
• wherein in each case a tunnel dielectric (35; 51) is provided between two adjacent magnetic layers (31, 32; 41-46).

2. The magnetoresistive read/write memory as claimed in claim 1, in which the magnetization directions (33, 34; 46-50) that can be set independently of one another in the individual layers (31, 32; 41-45) are set or can be set via different current intensities.

3. The magnetoresistive read/write memory as claimed in claim 1 or 2, in which the electric conductors (12, 13) are provided for high current densities.

4. The magnetoresistive read/write memory as claimed in any one of the claims 1 to 3, in which the magnetic layers (31, 32; 41-45) are formed from a ferromagnetic material.

5. The magnetoresistive read/write memory as claimed in any one of the claims 1 to 4, in which the intersecting conductors (12, 13) are aligned orthogonally to one another.

6. The magnetoresistive read/write memory as claimed in any one of the claims 1 to 5, in which the tunnel dielectric has a thickness of 2 to 3 nm.

7. A method for writing to a magnetoresistive read/write memory as claimed in any one of the claims 1 to 6, the method comprising the following steps:
a) impressing a variable electric current into the two electric conductors and, as a result, producing a magnetic field;
b) setting the magnetization direction in the individual magnetic layers of the multilayer system via the field strength of the magnetic field produced, the magnetization directions in the individual layers being set independently of one another via respectively differently high requisite field strengths, in such a way that the magnetization directions are set first in those layers which need the highest field strength for this purpose and that the magnetization directions are then set in those layers which respectively need a lower field strength for this purpose.

8. The method as claimed in claim 7, in which the different field strengths acting on the layers are produced by currents of different magnitudes being impressed into the conductors.

9. The method as claimed in claim 7 or 8, in which the different field strengths acting on the layers are produced by means of a different physical spacing of the layers in relation to the conductors.

10. The method as claimed in any one of the claims 7 to 9, in which the setting of the magnetization directions in the layers are influenced on the basis of field strengths of different magnitudes due to the layer material and/or the layer thickness and/or the layer morphology.

11. A method of reading from a magnetoresistive read/write memory as claimed in any one of the claims 1 to 6, the method comprising the following steps:
a) impressing a defined item of data into the individual layers of the multilayer system in such a way that the item of data is first impressed into that layer which needs the lowest field strength to set the magnetization direction, and that the item of data is then impressed into the layers having the respectively next higher requisite field strength; and
b) detecting a possible information change in the layer or the layers, respectively, on the basis of the impressed defined item of data.

12. The method as claimed in claim 11, in which the detection of a possible information change in the layer or the layers, respectively, is carried out by measuring the electrical resistance.

13. The method as claimed in claim 11 or 12, in which the detection of a possible information change in the layer or the layers, respectively, is carried out via a detection of current and/or voltage pulses.

14. The method as claimed in any one of the claims 11 to 13, in which the detection of a possible information change in the layer or the layers, respectively, is carried out before and after the impression and/or during the impression of the specific item of data into the layer or the layers, respectively.

15. The method as claimed in any one of the claims 11 to 14, in which an item of data with respectively the same value is successively impressed into all the layers.

16. The method as claimed in any one of the claims 11 to 14, in which an item of data which belongs to an alternating algorithm is impressed successively into the layers.

17. The method as claimed in any one of the claims 11 to 16, in which the results during the detection of a possible information change for each layer are intermediately stored, at least temporarily, in a storage device.

## Revendications

1. Mémoire d'écriture/lecture magnétorésistive comportant plusieurs cellules de mémoire polyvalentes (11), où chaque cellule de mémoire (11) comporte deux conducteurs électriques (12, 13), qui se croisent, ainsi qu'un système de couches, qui est situé au niveau du point de croisement des conducteurs électriques (12, 13) et est constitué de couches magnétiques,
dans laquelle
le système de couche est agencé sous la forme d'un système à couches multiples (30; 40) comportant deux ou plus de deux couches magnétiques (31, 32; 41-45),
au moins deux couches magnétiques et au maximum toutes les couches magnétiques (31, 32; 41, 45) possèdent des directions respectives d'aimantation (33, 34; 46-50) réglables d'une manière réciproquement indépendante,
la direction d'aimantation (33, 34; 46-50) dans les différentes couches (31, 32; 41-45) est modifiée ou peut être modifiée sur la base du courant électrique qui circule dans les conducteurs électriques (12, 13),
un diélectrique à effet tunnel (35; 51) est prévu respectivement entre deux couches magnétiques voisines (31, 32; 41-46).

2. Mémoire d'écriture/lecture magnétorésistive selon la revendication 1, dans laquelle les directions d'aimantation (33, 34; 46-50) réglables d'une manière réciproquement indépendante dans les différentes couches (31, 32; 41-45) sont réglées ou réglables au moyen d'intensités de courant différentes.

3. Mémoire d'écriture/lecture magnétorésistive selon la revendication 1 ou 2,
dans laquelle les conducteurs électriques (12, 13) sont conçus pour des densités de courant élevées.

4. Mémoire d'écriture/lecture magnétorésistive selon l'une des revendications 1 à 3,
dans laquelle les couches magnétiques (31, 32; 41-45) sont formées d'un matériau ferromagnétique.

5. Mémoire d'écriture/lecture magnétorésistive selon l'une des revendications 1 à 4,
dans laquelle les conducteurs (12, 13), qui se croisent, sont orientés en étant orthogonaux entre eux.

6. Mémoire d'écriture/lecture magnétorésistive selon l'une des revendications 1 à 5,
dans laquelle le diélectrique à effet tunnel possède une épaisseur comprise entre 2 et 3 nm.

7. Procédé d'écriture dans une mémoire d'écriture/lecture magnétorésistive selon l'une des revendications 1 à 6, comportant les étapes suivantes:
a) injection d'un courant électrique variable dans les deux conducteurs électriques et, de ce fait, production d'un champ magnétique;
b) réglage de la direction d'aimantation dans les différentes couches magnétiques du système à couches multiples au moyen de l'intensité du champ magnétique produit, les directions d'aimantation dans les différentes couches étant réglées d'une manière indépendante les unes des autres au moyen d'intensités de champ respectivement nécessaires ayant des valeurs différentes, de telle sorte que les directions d'aimantation sont réglées tout d'abord dans les couches, qui requièrent à cet effet l'intensité de champ maximum, et qu'ensuite on règle les directions d'aimantation dans les couches qui requièrent à cet effet respectivement une intensité de champ plus faible.

8. Procédé selon la revendication 7, selon lequel les intensités de champ différentes, qui agissent sur les couches, sont obtenues par le fait que des courants ayant des intensités différentes sont injectés dans les conducteurs.

9. Procédé selon la revendication 7 ou 8, selon lequel les intensités de champ différentes, qui agissent sur les couches, sont produites au moyen d'une distance spatiale différente des couches par rapport aux conducteurs.

10. Procédé selon l'une des revendications 7 à 9, dans lequel le réglage des directions d'aimantation dans les couches est influencé, sur la base d'intensités de champ ayant des valeurs différentes, au moyen du matériau des couches et/ou de l'épaisseur des couches et/ou de la morphologie des couches.

11. Procédé pour effectuer la lecture dans une mémoire d'écriture/lecture magnétorésistive selon l'une des revendications 1 à 6, présentant les étapes suivantes:
a) injection d'une donnée définie dans les différentes couches du système à couches multiples de telle sorte que la donnée est injectée tout d'abord dans la couche, qui requiert l'intensité de champ la plus faible pour le réglage de la direction d'aimantation, et qu'ensuite on injecte la donnée dans les couches avec les intensités de champ immédiatement plus élevées qui sont respectivement nécessaires; et
b) détection d'une modification possible de l'information dans la couche ou dans les couches sur la base de la donnée définie injectée.

12. Procédé selon la revendication 11, selon lequel la détection d'une éventuelle modification de l'information dans la couche ou dans les couches est réalisée au moyen d'une mesure de la résistance électrique.

13. Procédé selon la revendication 11 ou 12,selon lequel la détection d'une modification possible de l'information dans la couche ou dans les couches s'effectue au moyen d'une détection d'impulsions de courant et/ou de tension.

14. Procédé selon l'une des revendications 11 à 13, selon lequel la détection d'une modification possible de l'information dans la couche ou dans les couches s'effectue avant ou après l'injection et/ou pendant l'injection de la donnée déterminée dans la couche ou dans les couches.

15. Procédé selon l'une des revendications 11 à 14, selon lequel on injecte successivement dans toutes les couches une donnée ayant respectivement la même valeur.

16. Procédé selon l'une des revendications 11 à 14, selon lequel on injecte successivement dans les couches une donnée, qui satisfait à un algorithme alternatif.

17. Procédé selon l'une des revendications 11 à 16, selon lequel les résultats obtenus lors de la détection d'une modification possible de l'information pour chaque couche sont mémorisés au moins temporairement dans un dispositif de mémoire.
